# EUROPEAN PATENT APPLICATION

(11) **EP 1 950 796 A2**
(43) Date of publication of application: **30.07.2008**
(21) Application number: 06841690.8
(22) Date of filing: 10.11.2006
(51) Int. Cl.: H01L 21/20

(54) **METHOD OF REDUCING EXCESS NOISE IN ELECTRONIC DEVICES**

(30) Priority: 10.11.2005 ES 200502744
(71) Applicant: Universidad Politécnica de Madrid, 28040 Madrid (ES)
(72) Inventor: IZPURA, José Ignacio, E-28040 Madrid (ES)
(74) Representative: Carvajal y Urquijo, Isabel
(86) International application number: PCT/ES2006/000620
(87) International publication number: WO 2007/054595

(57) **Abstract**

This invention proposes the use of a thermodynamic screen placed under the electronic devices whose excess noise is to be reduced in order to block the transverse currents between said devices and subjacent layers that are responsible for the aforementioned excess noise. For epitaxial layers as those used in Microelectronics, the barrier layer (2) with an opposed doping to the epilayer supporting the devices (4), and the non-doped separating layer (3) form the thermodynamic screen which, embedded between the epilayer (4) and the substrate (1), reduces the aforementioned transverse currents and thus the excess noise of the devices on the epilayer (4) when they are biased. The connection between the ohmic contact (7) of the screen layer (2) with the source (6) of the FET transistors of the epilayer (4) (dashed line) or with their gate (5) removes the thermal noise of the capacitor that existed under those FET transistors and hence, the corresponding excess noise in these devices

## Description

### Field of Invention

The invention falls in the field of electrical devices and more specifically in the semiconductor-based devices widely used in microelectronics both as discrete as well as monolithically integrated devices. More specifically it pertains to the area of noise reduction techniques for low-frequency excess noise in devices.

### Background of the invention

From the early observations of flicker noise in vacuum tubes in 1925, this kind of noise also found in solid-state devices and known as excess noise in resistors because it emerges over their thermal noise at low frequencies, always is found when a current flows in electrical devices. In regards to this noise, GaAs devices made on semi-insulating (SI) GaAs substrates are very noisy, thus being problematic for mixers due to noise upconversion effects that appears when the high level of noise at low frequencies of the mixing device (a MESFET for example) is translated to frequency bands where it degrades the system performances. Nevertheless, SI-GaAs substrates are widely used in Monolithic Microwave Integrated Circuits (MIMICs) due to the good isolation that they provide when the epilayer existing between devices is removed by etching for example. GaAs devices made on p-type GaAs substrates that would to have similar devices made from a high mobility n-type epilayer on the substrate and also would bear a similar isolation between devices at dc and low frequencies, fail to isolate them at microwave frequencies due to the capacitive coupling between the conducting substrate and the devices of the high mobility n-type layer on top. Therefore a way to reduce excess noise in GaAs devices on SI-GaAs substrates or on substrates giving a good isolation between devices it is highly desirable.

On the other hand, Silicon Microelectronics also suffers from this ubiquitous excess noise found both as a 1/f noise spectrum over thermal noise at low frequencies as well as one or more Lorentzian noise spectra emerging over thermal noise in the same low-frequency region, that sets a limit to the low-frequency performances of sensors and amplifiers working at or near zero frequency (dc). Although some improvements are being achieved in regards to this noise, the problem still remains unsolved due to the enigmatic and unknown origin of the so called 1/f noise in electrical devices. And especially important was the lack of an electrical origin for this 1/f noise like the one that has led to this invention. Due to the above, many sensors that would have to work from frequencies approaching dc are modulated by a carrier to avoid the 1/f noise band, thus increasing complexity and cost of the sensing system comprising a modulator and a coherent detector. All these drawbacks would be removed by an efficient method to remove such excess noise in silicon based devices, and the interest of the method would be more desirable if it was applicable to other semiconductor materials as GaN for high temperature applications, CdTeHg for infrared radiation detectors and so on.

The state of the art concerning excess noise reduction in devices is at its early stages due to the lack of a technical and convincing explanation on the origin of excess noise in electrical devices. In spite of this, some empirical ways to reduce excess noise have appeared over the course of time as the well known approach making use of broad area devices like Fat-FETs, but this is done at the cost of a higher silicon waste in the Integrated Circuits where such devices are and the input impedance of the devices is decreased. As a very different approach not requiring broad area devices, a very recent patent [1] has been found that, like the method of this invention, uses a technology processing to reduce excess noise. The processing of [1] aims to reduce carrier traps in MOS (Metal-Oxide-Semiconductor) devices by using fluorine to reduce the number of carrier traps which are believed in [1] to be the origin of the low frequency excess noise in MOS devices. This is written in [1] as: *"ADVANTAGE- The inventive method is capable of reducing 1*/*f noise of the MOS device thus providing high performance analog integrated circuits. The presence of fluorine reduces the number of traps in the gate dielectric that carriers can translocate to".* This invention explained by a classical theory involving carrier traps and its reduction has a doubtless merit for the particular process protected by the patent [1], but technically it is completely apart from our invention. The more radical difference among this fluorine-based process [1] and our invention is in the very different regions of a MOS device considered in [1] and in our invention. Whereas the dielectric existing between the top surface of the channel of the MOS and its metallic gate on top is considered in [1], our invention consider just the opposed surface of the channel: its bottom interface with the substrate or layers underneath, no matter if this channel is the channel of a MOS device or a different channel. This makes our invention applicable not only to MOS devices as those in [1], but also to other devices having planar channels as Junction and Heterojunction Field-Effect Tansistors (JFET and HFET), Metal gate FETs (MESFET), planar resistors and hence, those devices including them in their inner structure as Bipolar Junction Transistors (BJT) and Heterojunction Bipolar Transistors .

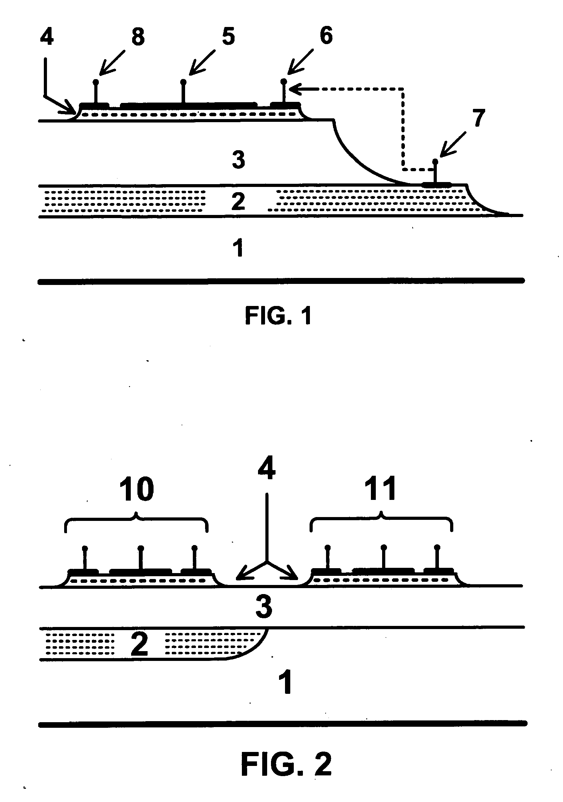

This radical invention comes from a novel theory that I have published recently, showing how excess noise is a consequence of transversal currents to the epilayer where the devices are, a kind of currents that are reinforced by the own biasing of the devices, being this an unpublished idea to my knowledge. The theory behind this invention departs radically from currently used theories that try to explain excess noise as an effect due to carrier traps, carefully designed to produce something like a 1/f noise spectrum. To say it bluntly, my novel theory leaves aside such hypothetical carrier traps and shows that the excess noise comes from the undeniable parasitic devices and effects that have been overseen (or not considered as such parasitics) over the course of time, more than eighty years ago. From this novel and electronic explanation for the excess noise as an effect of the transversal currents flowing through the parasitic capacitor that is formed under the devices of the epilayer, this novel and radical idea appears in a natural way: to block or to weaken said transversal currents (even removing them in some cases) by what we have called "thermodynamic screen". This name comes from the fact that said screen aims to block or weaken the carrier fluxes (currents) going normally to the plane of the epilayer (4) of Figure 1 and this can be done in several ways. One is by a proper doping as shown in Figure 1, but another possible way is by a careful use of heterojunctions instead of junctions (band engineering) that can help to relax some doping or other requirements while achieving similar results. Therefore, the novelty of this invention is the use of this thermodynamic screen under the devices and, derived from its electrical screen effect appears the use of Surrounding-Gate Field-Effect Transistors (FET) to have a low excess noise in devices and monolithic integrated circuits as Operational Amplifiers for example.

In summary, present invention is based on an electrical origin of the excess noise in electrical devices that has not been considered in the years elapsed from the first observations of "flicker noise" by Johnson in 1925. This electrical origin was unknown to most scientist being not worried about excess noise or accepting theories more or less sophisticated as those assigning excess noise to carrier traps, temperature fluctuations and similar phenomena taking place where the aforementioned excess noise appears. This kind of theories makes difficult the appearance of an electrical or technological solution to reduce excess noise in semiconductor devices, but considering the electrical origin and thermodynamical character of the excess noise offered by the theory that backs present invention, excess noise reduction becomes easy to carry out and at a low cost as compared to the performances that can be achieved, all being promising for the industrial exploitation of this invention.

### [1] "Reduction of noise in metal oxide semiconductor device involves implanting fluorine dopant into polysilicon at specified implant dose, and thermally annealing the polysilicon layer to diffuse the fluorine dopant into the oxide layer". Patent number:US2005136579-A1.

### Brief description of the drawings

Both to illustrate the state of the art as well as to complement the description of this invention, a set of figures is provided which does not intend to be limitative but only illustrative. It comprises the following:
**Figure 1**.- It shows the cross section of layers required onto a substrate together with their connection, proposed to obtain a thermodynamic screen to reduce or remove, by the dashed connection between (7) and (6) or between (7) and (5), the excess noise of the devices in the epilayer (4) due to transversal currents flowing between the epilayer (4) and the substrate (1).
**Figure 2****.-** It shows the cross section of the layer structure that results when this invention is applied to devices grown on semi-insulating GaAs substrates using well known processes used in today's microelectronics.
**Figure 3**.- It shows the band diagrams that allow to see the energy barrier that the proposed thermodynamic screen produces to reduce transversal currents in the layer structure of Figure 2 where such screen exists.
**Figure 4****.**- It shows the electrical cross section of an electrical device (a nanowire for example) formed by an inner conducting channel of resistance R_{ch} ohms enclosed by a conductor (15) surrounding the channel.
**Figure 5****.**- It shows the way our method applies to the structure of Figure 4 to reduce its excess noise by the electrical connection (16) of the surrounding conductor to the end of the inner conducting channel of resistance R_{ch}

### Description of the invention

From the theory backing this invention, excess noise in electrical devices is due to unwanted currents flowing orthogonally to the main current in the devices which flows in the plane of the epilayer where the devices have been fabricated. These transversal currents to the epilayer flow from the devices to the substrate and viceversa, being this the reason why this invention tries to remove or to reduce the aforementioned transversal currents by using a proper screen in the neighbourhood of the devices whose excess noise is to be reduced.

For devices on semi-insulating GaAs substrates made from current technology, the epitaxial GaAs layer (epilayer) used to make these devices is grown directly on the substrate or on a buffer layer grown previously that improves the morphology of further growth. We propose to include a simple buffer designed for a purpose not proposed previously: to serve as the shield or thermodynamic screen described in this invention. Since the epilayer (4) of Figure (1) uses to be n-GaAs (due to the higher mobility for electrons than for holes), a low-barrier junction or low built-in contact potential (V_{bi}) junction will be formed between the substrate and the epilayer grown directly onto the semi-insulating substrate, whose reverse saturation currents are very high. This is the situation that exists with today's technology, that can be seen in Figure 1 if layers (2) and (3) (screen and separating layers respectively) were removed. Due to this fact, small bias voltages applied to the devices in the epilayer (4) give rise to high transversal currents between epilayer and substrate, and therefore a high excess noise is generated in the devices as the FET transistor whose cross section involving its Source (6), Gate (5) and Drain (8) electrodes is shown in Figure 1: Nevertheless, the aforementioned transversal currents can be reduced by order of magnitude by embedding a p⁺ or p-type GaAs screen-layer (2) between the epilayer (4) and the semi-insulating GaAs substrate (1). In this case, the junction formed between the epilayer (4) and the screen-layer (2) is a p-n or p⁺-n GaAs junction having a much higher V_{bi} than the V_{bi} of the low-barrier junction that is formed by current technology and hence the much weaker transversal currents and the much lower excess noise existing in those devices protected by the thermodynamic screen formed by two layers: the screen layer (2) and the separating layer (3) of Figure 1.

Although the separating layer (3) would seem unnecessary to obtain a junction with high built-in contact potential V_{bi}, this separating layer (3) is highly beneficial because besides its contribution to excess noise reduction, it is excellent for the high frequency performances of the devices. This is so because without the separating layer (3), the capacitance per unit area of the p⁺-n junction formed by the epilayer (4) grown directly onto the screen-layer (2) would be high, thus giving a high capacitance C_{DS} between the drain (8) and source (6) of the FET of Figure 1. This not only would increase the excess noise, but also it would degrade completely the high frequency performances of the FET. Nevertheless, the growth of a separating layer of undoped GaAs (3) having 1 or 2 micron thickness will reduce C_{DS} roughly 20 times, thus leaving a FET with good performances at high frequencies as well as with a low excess noise. It is worth noting that the the undoped GaAs layer (3) between the epilayer (4) and the screen-layer (2) does not change the high V_{bi} character of the (p⁺-i-n) junction in regards to the transversal currents that will flow from the epilayer (4) to the screen-layer (2) and viceversa, thus leading to very low values for these transversal currents and its associated excess noise. And moreover: the excess noise can be made null by the electrical connection that we have proposed by the dashed line of Figura 1, going from the ohmic contact (7) of the screen-layer (2) to the source (6) of the FET in the epilayer (4). Also it is worth noting that if we don't want to have the double isolation in dc and radiofrequency provided by a semi-insulating GaAs substrate, a conducting p-GaAs substrate could be used that would act as screen-layer, thus requiring only the separating layer of undoped GaAs to reduce C_{DS} in order to reduce excess noise in the devices together with an acceptable response at high frequencies.

In those applications where the capacitor C_{DS} does not need to be reduced (typically in low frequency applications) the separating layer (3) can be omitted, and moreover, the screen-layer (2) can be connected to the gate of the FET (5) of the epilayer (4), thus obtaining in this way a surrounding gate FET whose use as very low excess noise device also claims this invention due to the screen-layer function that layer (2) continues doing, although converted also in a part of the control gate of the FET, similar to its control gate (5). This would be the case of other devices not intended for radiofrequencies, as devices on Silicon for audiofrequencies and other devices as photodetectors UV and IR based on GaN and CdHgTe for example.

### Embodiments of the invention

This invention is illustrated by the following examples which are not intended to limit its scope nor its applicability.

### Example 1

Figure 2 shows an optimized application of the method of Figure 1 for its use with semi-insulating GaAs substrates that allows to have regions with isolated devices with very good performances at high frequencies (11) and other regions (10) with very low excess noise devices protected by this invention, dedicated to local oscillator and mixing functions, all in the same monolithic integrated circuit (IC). The layer structure could be obtained easily starting from a semi-insulating GaAs substrate (1) where an initial p-type implantation or diffusion (2) would be done in those regions where the low excess noise resistors and transistors will be fabricated (note that a resistor has the same structure of the FET whose cross section appears in Figure 1, if the gate terminal (5) is not fabricated and the Source (6) and Drain (8) terminals are used as the resistor's terminals). In this way we would obtain the screen-layers (2) under the low excess noise devices. The depth of said diffusion could be 0.3 microns with a doping in the range 5×10¹⁷ acceptors/cm³. These screen-layers are going to be buried under the low excess noise transistors and even left unconnected to the source of these transistors they will do an excellent reduction of excess noise because they will reduce drastically the vertical currents in Figure 2 for the transistors they have on top. After this initial diffusion or implantation, an undoped GaAs layer of thickness close to 1 micron would be grown for the separating layer (3) that also would serve as a buffer to improve the crystalline quality of the GaAs growth that would be a very good one when the n-GaAs epilayer (4) was grown on top having a thickness of 0.3 microns and a doping level of 4×10¹⁷ donors/cm³ typically. Since the screen-layer only exists in localized regions of the chip, those devices not being over one of these screen-layers (11) would be quite well isolated at high frequencies by the undoped GaAs layer and the semi-insulating substrate they have underneath and, although they would have a higher excess noise than those devices being onto the screen-layers (10), they would have a lower C_{DS} capacitance that would make them suitable to amplify signals at several GHz where the excess noise (near dc) is irrelevant.

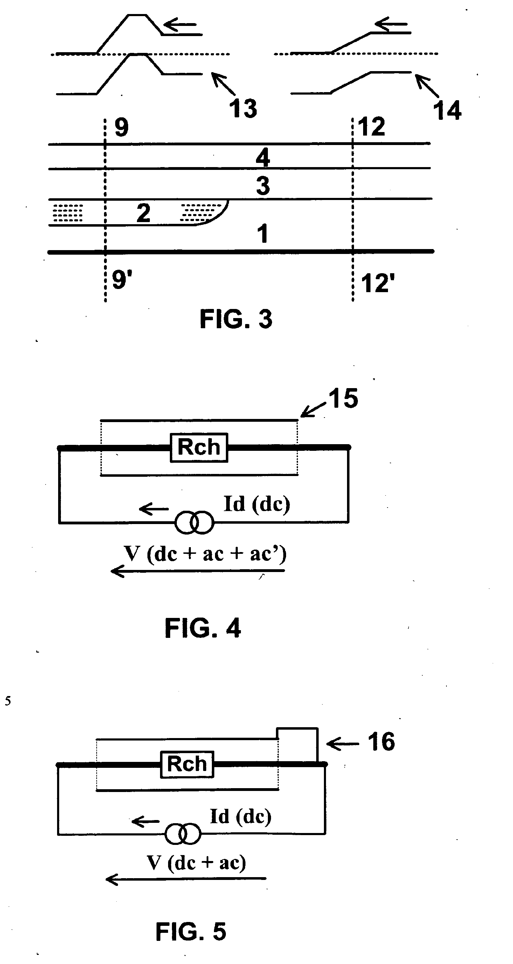

In this way we have on the same monolithic integrated circuit both conventional (11) transistors and resistors (devices) and low excess noise devices (10) more suitable for mixing and high purity local oscillation functions, specially if the required processes to connect the screen-layer (2) to the sources of the devices are done for those mixing and oscillating transistors more convenient for this connection. Figure 3 shows the band diagrams along a vertical direction in Figure 2, for the case where the p-type screen-layer is crossed (cut 9-9') or not (cut 12-12'). The corresponding band diagrams (13) and (14) along cuts 9-9' and 12-12' show why a thermodynamic screen is obtained that blocks or reduces the transversal currents from the epilayer (4) to the substrate (1) and viceversa. The band diagram (13) shows clearly the energy barrier that exists for these currents, a barrier that is absent in the band diagram (14) that is obtained without the aforementioned thermodynamic screen. The horizontal arrow in each band diagram (13) and (14) illustrates the carrier flux from the substrate to the epilayer, although an equal and opposed carrier flux would exist simultaneously thermal equilibrium (not shown for clarity purposes). It is apparent the additional barrier created by the p-type GaAs screen-layer (2) having in this example a p-doping opposed to the n-doping of the epilayer (4), but there are other methods, as those using band-engineering (heterojunctions), that also lead to create or to improve the barrier effect described in this example.

### Example 2

Figure 4 shows the electrical cross section of many electrical devices having an inner conductive channel of a given resistance R_{ch} surrounded by a neighbour conductor going in a roundabout way (14) to the former but isolated from it, that by Electrostatic laws forms a capacitor C surrounding the inner channel. The electrical geometry of Figure 4 appears in many electronic devices going from a simple coaxial cable to a more sophisticated conducting filaments as the microwires and nanowires under active research today. From today's knowledge on excess noise, the resistance R_{ch} of the inner channel when driven by the continuous (dc) current I_{d} will allow to obtain a voltage V on the resistance R_{ch} that will show a dc term given by Ohms Law: V_{dc}=I_{d}×R_{ch} and two small noise terms (ac) and (ac'), one being the thermal noise of the resistance R_{ch} also known as Johnson noise and the second being a term not satisfactorily explained up to now that is the excess noise appearing for enough I_{d} flowing along the inner channel of resistance R_{ch}. No simple cure or remedy for this excess noise results from the above, but using our novel theory about excess noise, Figure 5 shows the simple connection (15) we have to do to reduce and remove in some cases the excess noise term (ac'). This connection plays the same role that played in Figure 1 the connection done by a dashed line, which has inspired this one. Such role is to make null the thermodynamic noise of the surrounding capacitor C (its kT/C noise) that exists between the inner conductor and the outer conductor when they are left unconnected, as they appear in Figure 4. The connection (15) will remove the excess noise measured on the resistance R_{ch} of the inner channel caused by currents transversal to the inner channel, that include both those currents due to the kT/C noise as well as the additional transversal currents induced by the voltage V_{dc} appearing on R_{ch}. The connection (15) can be done by a short circuit (that is a voltage generator of zero volts and very low impedance) but it will be also equally effective to reduce excess noise if it is done by means of a low impedance voltage generator also giving some dc or ac voltage signal. Since the novel theory that backs this invention predicts that the excess noise of small devices as nanowires will be high due to their low surrounding capacitance C bearing a high kT/C noise creating a correspondingly high excess noise), hence the interest of our method to reduce excess noise in small devices as a nanowire-based resistor by shorting one of the ends of its channel to a neighbour conductor surrounding the small and conducting channel no matter its nature (a nanowire, a nanotube and so on).

An interesting application of this method to reduce excess noise in monolithic integrated circuits is the use of Surrounding Gate Field Effect Transistors (SGFET) in the input stage of a monolithic Operational Amplifier. In this case the input SGFET will be using the connection shown in Figure 5 through the low impedance path of the voltage generator V_{GS} driving the aforementioned SGFETs. Going back to Figure 1, a SGFET was created when we used the second option we proposed to remove excess noise in the devices by connecting the ohmic contact (7) of the screen-layer (2) to the gate terminal (5), thus shorting the capacitor that existed under the FET transistors of the epilayer (4) before making said connection. The use of SGFETs used in the input stage of a monolithic Operational Amplifier would not need to be the "fatFETs" already commented but they could be truly small devices to increase the input impedance of the monolithic integrated Operational amplifier used as example.

## Claims

1. Method to reduce excess noise in planar electronic devices **characterized by** the use of a thermodynamic barrier for charge carriers, formed by a screen-layer (2) whose doping is opposed to the doping of the epilayer (4) used to make the devices and an undoped, separating-layer (3) embedded between the devices and the screen-layer (2), all the above grown or placed onto a substrate (1) that can be a semi-insulating substrate or a conducting substrate, being the latter useful as screen-layer if its doping is opposed to the doping of the epilayer (4) used to make the devices.

2. Method to reduce excess noise in planar electronic devices following claim 1^{st}, **characterized by** a low impedance electrical connection of the screen-layer (2) of the aforementioned thermodynamic screen to the Source (6) or to the Gate (5) of the field effect transistors in the epilayer (4) or to one of the Source (6) or Drain (8) ends of the resistors in the epilayer (4), obtained as simplified versions of the aforementioned field effect transistors when the Gate (5) does not exist or when it is connected to one of the ends Source (6) or Drain (8) of the resistor obtained in this way.

3. Use of the method to reduce excess noise described in claims 1^{st} and 2^{nd} for those devices **characterized by** a structure comprising an inner conducting channel surrounded by a neighbour conductor **that is done by** the electrical connection of the surrounding conductor to one of the ends of the inner conducting channel directly, or through a low-impedance circuit allowing an efficient reduction of the amplitude of thermodynamic kT/C noise that would have the capacitance C between the inner channel and the outer conductor before the proposed connection was done.
